# EUROPÄISCHE PATENTSCHRIFT

(11) **EP 2 159 362 B1**
(45) Veröffentlichungstag und Bekanntmachung des Hinweises auf die Patenterteilung: **08.03.2017**
(21) Anmeldenummer: 08105204.5
(22) Anmeldetag: 02.09.2008
(51) Int. Cl.: E05F 15/73, B60R 25/00, G07C 9/00, H03K 17/955

(54) **Kraftfahrzeug mit einer Einrichtung zum selbsttätigen Öffnen wenigstens einer Klappe des Kraftfahrzeugs**
Vehicle with a device for automatic opening of at least a vehicle flap
Véhicule avec dispositif d'ouverture automatique d'un volet de véhicule

(43) Veröffentlichungstag der Anmeldung: 03.03.2010
(73) Patentinhaber: Hella KGaA Hueck & Co., 59552 Lippstadt (DE)
(72) Erfinder: Weghaus, Ludger, 59556, Lippstadt (DE); Marx, Bernhard, 59590, Geseke (DE)

(56) Entgegenhaltungen:
- EP-A- 1 902 912
- EP-A- 1 956 170
- WO-A-2006/024399
- GB-A- 2 376 075
- GB-A- 2 386 958

## Beschreibung

Die vorliegende Erfindung richtet sich auf ein Kraftfahrzeug mit wenigstens einer Klappe, die nach einem Öffnungsbefehl selbsttätig öffnet oder nach einem Schließbefehl selbstständig schließt, wobei wenigstens ein erster Sensor mit einem ersten, horizontalen Wirkbereich und wenigstens ein zweiter Sensor mit einem zweiten, vertikalen Wirkbereich am Kraftfahrzeug vorgesehen ist, wobei der Öffnungsbefehl wenigstens teilweise durch die Sensoren auslösbar ist.

Aus der WO 2006/024399 A1 ist ein Kraftfahrzeug mit einer selbsttätig öffnenden Klappe bekannt. Das Kraftfahrzeug besitzt wenigstens einen ersten Sensor, der als Bestandteil eines Abstandserfassungssystems ausgeführt ist, der einen horizontalen Wirkbereich besitzt. Damit können Personen oder Gegenstände detektiert werden, die sich dem Fahrzeug nähern oder denen sich das Fahrzeug nähert. Ein zweiter Sensor mit einem vertikalen Wirkbereich am Kraftfahrzeug ist als Näherungssensor ausgeführt und besitzt einen vertikalen Wirkbereich, der durch den Sensor überwacht wird. Der zweite Sensor mit dem vertikalen Wirkbereich ist derart angeordnet, dass ein Benutzer ihn durch Schwenken des Fußes im Bereich zwischen dem Fahrzeugaufbau und der Fahrbahnoberfläche zur Schaltung veranlassen bzw. schalten kann. Dieser Näherungssensor kann unterhalb eines am Kraftfahrzeug vorhandenen Stoßfängers oder auf der unteren Seite eines Stoßfängers in diesen integriert angeordnet werden.

Bekannte Sensoren zur Bereitstellung eines Öffnungsbefehls zum Öffnen wenigstens einer Klappe eines Kraftfahrzeuges besitzen den Nachteil, dass diese als Ultraschallsensoren oder als Radarsensoren ausgeführt sind. Derartige Sensoren sind als Parkabstandskontrolle bekannt, die dann aktiviert wird, wenn das Fahrzeug eingeparkt wird oder sich Gegenstände in der Nähe des Fahrzeuges befinden. Gemäß dem bekannten Stand der Technik werden diese Parkabstandskontrollsysteme (PDC - Park Distance Control) dazu verwendet, den Öffnungswunsch zur Öffnung einer Klappe des Kraftfahrzeuges vom Benutzer zu erkennen. Der Benutzer kann sich bei stehendem Fahrzeug von der Rückseite an das Fahrzeug annähern, so dass die Annäherung der Person durch das Parkabstandskontrollsystem detektiert wird. Der zweite unterseitig am Fahrzeug angebrachte Sensor sensiert die Bewegung des Fußes oder des Beines des Benutzers, wodurch der Benutzer den Wunsch signalisiert, beispielsweise den Kofferraum des Kraftfahrzeuges zu öffnen. Derartige "virtuelle Pedale" sind dann hilfreich, wenn der Benutzer Gegenstände in den Händen trägt, wodurch eine manuelle Öffnung des Kofferraumes des Kraftfahrzeuges erschwert ist.

Bekannte Systeme zur Erkennung des Öffnungswunsches einer Klappe eines Kraftfahrzeuges durch einen Benutzer besitzen jedoch den Nachteil, dass die hierfür verwendeten Sensoren des Parkabstandskontrollsystems als Radarsensoren oder Ultraschallsensoren ausgeführt sind. Derartige Sensoren sind durch einen hohen Stromverbrauch gekennzeichnet, so dass diese nicht dauerhaft eingeschaltet bleiben können. Folglich muss erst eine Aktivierung der Sensoren beispielsweise durch ein Zugangsberechtigungsmittel erfolgen, die in Form von ID-Gebern bekannt sind und auch als Key-Less-Go-Card bezeichnet werden. Derartige Zugangsberechtigungsmittel dienen zur Authentifizierung der Person, die Zugang zu dem Kraftfahrzeug besitzt und durch die der Öffnungswunsch beispielsweise des Kofferraumes des Kraftfahrzeuges legitimiert ist. Jedoch muss nachteilhafterweise zuerst die Identifikation erfolgen, um die Ultraschall- oder Radarsensoren des Parkabstandskontrollsystems zu aktivieren, so dass der erhöhte Stromverbrauch zeitlich begrenzt ist.

Es ist daher die Aufgabe der vorliegenden Erfindung, ein Kraftfahrzeug mit einer Einrichtung zum selbsttätigen Öffnen wenigstens einer Klappe zu schaffen, das die Nachteile des vorgenannten Standes der Technik vermeidet und bei einer dauerhaften Bereitschaft der Einrichtung einen einfachen Aufbau aufweist.

Diese Aufgabe wird ausgehend von einem Kraftfahrzeug mit einer Einrichtung zum selbsttätigen Öffnen wenigstens einer Klappe des Kraftfahrzeuges gemäß dem Oberbegriff des Anspruches 1 in Verbindung mit den kennzeichnenden Merkmalen gelöst. Vorteilhafte Weiterbildungen der Erfindung sind in den abhängigen Ansprüchen angegeben.

Die Erfindung schließt die technische Lehre ein, dass die Sensoren als kapazitiv wirkende Sensoren ausgebildet sind und Mittel aufweisen, mit denen eine Änderung einer kapazitiven Kopplung zwischen den Mitteln und einer Umgebung der Mittel sensierbar ist.

Dadurch wird der Vorteil erreicht, dass die Einrichtung zum selbsttätigen Öffnen wenigstens einer Klappe des Kraftfahrzeuges unabhängig vom Parkabstandskontrollsystem wirken kann. Sowohl der erste Sensor mit dem ersten, horizontalen Wirkbereich als auch der zweite Sensor mit dem zweiten, vertikalen Wirkbereich ist als kapazitiver Sensor ausgebildet.

Die Umgebung der Mittel beschreibt die Einbauumgebung der Mittel in das Fahrzeug. Damit ist sowohl die Umgebung im rückseitigen Bereich als auch die Umgebung unterhalb des Rückbereiches des Fahrzeuges erfasst. Die Mittel der Sensoren können als Sensorelektroden ausgebildet sein, so dass der erste Sensor eine erste Sensorelektrode und der zweite Sensor eine zweite Sensorelektrode besitzt. Die Sensoren selbst besitzen eine Sensorelektronik, die für eine hinreichend große Ladung auf den Sensorelektroden sorgt. Je nach Stärke der kapazitiven Kopplung zwischen der Sensorelektrode und der Umgebung bildet sich die jeweilige Ladung auf der Sensorelektrode aus. Nähert sich eine Person oder ein Gegenstand den Sensoren, so kann mehr Ladung auf den Sensorelektroden aufgebracht werden. Diese Ladung auf der Sensorelektrode wird in einen in der Elektronik befindlichen Referenzkondensator umgeladen. Durch häufige Wiederholung dieses Vorganges (Laden der Sensorelektrode, dann Umladen auf Referenzkondensator) akkumuliert sich die Ladung auf dem Referenzkondensator, dessen aufsummierte Ladung dann zu einer nutzbaren Signalauswertung herangezogen wird.

Die Aufsummierung der Ladung kann durch die Sensoren gemessen werden. In Abhängigkeit der Ladung auf der Oberfläche der Sensorelektroden kann ein Rückschluss gefunden werden, welche Änderung der Entfernung des Gegenstandes oder der Person vorliegt. Die Elektronik des Sensors stellt diese Information bereit, wobei beide Sensorelektroden auch einen gemeinsamen Sensor mit einer einzigen Sensorelektronik umfassen können. Ein derartiges Sensorsystem besitzt eine sehr niedrige Stromaufnahme, so dass eine dauerhafte Überwachung sowohl des ersten horizontalen Wirkbereichs als auch des zweiten vertikalen Wirkbereichs am Kraftfahrzeug möglich ist.

Es ist von Vorteil, dass zumindest eine der Sensorelektroden als flächenförmiges Element ausgebildet ist, wobei am Kraftfahrzeug ein Stoßfänger vorhanden ist, in oder an dem das oder jedes flächenförmige Element anordbar ist. Insbesondere kann jede der Sensorelektroden auf der Innenseite des Stoßfängers aufgebracht werden. Die Aufbringung kann durch ein Verkleben der Sensorelektrode auf der Innenseite des Stoßfängers beruhen, wobei die Sensorelektrode auch mittels Halteelementen angeklipst werden kann. Ferner ist die Integration der Sensorelektrode in das Material des Stoßfängers bereits bei der Herstellung des Stoßfängers möglich, beispielsweise als Einlegeelement beim Kunststoffspritzguss des Stoßfängers.

Das flächenförmige Element zur Bildung der Sensorelektrode kann als ein Draht oder eine Leiterfolie ausgeführt sein, wobei auch auf den Stoßfänger oder weiteren Fahrzeugteilen ein Aufdampfen oder Besputtern zur Bildung der Sensorelektrode möglich ist. Der Draht oder die Leiterfolie ist wenigstens über einen Teil der Breite des Stoßfängers des Kraftfahrzeuges in oder am Stoßfänger verlegt. Damit kann ein breiter Bereich des Kraftfahrzeuges erfasst werden, innerhalb dessen die Erkennung der Person möglich ist.

Die Sensorelektroden können im oder am Kofferraumdeckel, einem Flügelelement oder dergleichen angeordnet werden, und müssen nicht zwingend im Stoßfänger des Kraftfahrzeuges integriert sein. Ferner sind Kraftfahrzeuge bekannt, dessen Stoßfänger keinen unterseitigen und einen eher horizontal verlaufenden Bereich aufweist. Hierfür kann eine zusätzliche Halterung vorgesehen sein, um den zweiten Sensor mit dem zweiten, vertikal ausgebildeten Wirkbereich am Kraftfahrzeug anzuordnen.

Besonders bevorzugt ist die Klappe am Kraftfahrzeug als Kofferraumdeckel des Kraftfahrzeuges ausgebildet, wobei die Sensoren zur Detektion der Annäherung und/oder des Vorhandenseins einer Person und/oder eines Gegenstandes ausgeführt sind. Die Klappe am Kraftfahrzeug kann jedoch auch eine Tür betreffen, so dass die Person ohne manuelle Bedienung der Tür eine Öffnung der Tür über das "virtuelle Pedal" bewirken kann. Die Anordnung der Sensoren sollte dabei nicht in dem Bereich erfolgen, in dem die Person in den Schwenkbereich der Tür des Kraftfahrzeuges eintreten muss.

Wenigstens der erste Sensor mit horizontalem Wirkbereich, jedoch auch der zweite Sensor mit vertikalem Wirkbereich kann zur Detektion von Gegenständen genutzt werden, so dass durch die kapazitiv wirkenden Sensoren eine elektronische Einparkhilfe oder eine elektronische Rangierhilfe bereitgestellt werden kann, um vorhandene Parkabstandskontrollsysteme zu ergänzen, ohne eine genaue Information über einen Abstand zu einem Gegenstand oder einer Person bereit zu stellen. Die Anordnung einer oder jeder Sensorelektrode kann im Stoßfänger des Kraftfahrzeuges erfolgen, wobei auch eine Anordnung in einem Flügelelement oder dergleichen möglich ist, und wobei auch der zweite Sensor mit vertikalem Wirkbereich beispielsweise unterseitig am Kofferraumdeckel angeordnet werden kann.

Über der Breite des Fahrzeuges kann sowohl ein erster Sensor mit einem horizontalen Wirkbereich mehrfach angeordnet werden, wobei auch der zweite Sensor mit dem vertikalen Wirkbereich mehrfach unterseitig am Kraftfahrzeug eingebracht sein kann. Ferner besteht die Möglichkeit, das flächenförmige Element derart auszubilden, dass dieses sowohl die erste als auch die zweite Sensorelektrode bereitstellt, so dass durch die Elektronik im Sensor eine Unterscheidung der Detektion einer Person oder eines Gegenstandes im horizontalen Wirkbereich vom vertikalen Wirkbereich unterschieden werden kann. Eine besonders einfache Ausführung ist ermöglicht, wenn die erste Sensorelektrode im vertikal verlaufenden und zur Rückseite weisenden Bereich des Stoßfängers und die zweite Sensorelektrode im wenigstens näherungsweise horizontal verlaufenden und zur Unterseite weisenden Bereich des Stoßfängers angeordnet ist.

Erfindungsgemäß werden die Sensoren über eine Verbindungsleitung mit einem Steuergerät wirkverbunden, wobei das Steuergerät die Information der Sensoren auswertet und gegebenenfalls in einen Öffnungsbefehl umwandelt, um beispielsweise die Verriegelung der Klappe wie des Kofferraumdeckels zu aktivieren und eine Öffnung des Kofferraumdeckels zu bewirken.

Ein Zugangsberechtigungsmittel ist vorgesehen das mit dem Steuergerät mittels einer drahtlosen Verbindung verbindbar ist und durch das Steuergerät abfragbar ist, ob der Öffnungsbefehl zur selbsttätigen Öffnung der Klappe ausgelöst werden darf oder nicht. Ist kein Zugangsberechtigungsmittel vom Steuergerät beispielsweise über eine Funkverbindung detektierbar, so wird trotz der Detektion einer Person durch den oder die Sensoren mit dem horizontalen Wirkbereich und den oder die Sensoren mit dem vertikalen Wirkbereich die Öffnung der Klappe nicht ausgelöst. Jedoch dient die Abfrage des Zugangsberechtigungsmittels, beispielsweise einem ID-Geber oder einer Key-Less-Go-Card, nicht dazu, einen der Sensoren zu aktivieren. Die Abfrage des Zugangsberechtigungsmittels stellt lediglich eine zusätzliche Sicherheit dar, ein unberechtigtes Öffnen der Klappe des Kraftfahrzeuges zu vermeiden.

Die vorliegende Erfindung richtet sich ferner auf ein Verfahren zur Auslösung eines Öffnungsbefehles zum selbsttätigen Öffnen wenigstens einer am Kraftfahrzeug vorhandenen Klappe, wobei ein erster Sensor mit einem ersten, horizontalen Wirkbereich und wenigstens ein zweiter Sensor mit einem zweiten, vertikalen Wirkbereich am Kraftfahrzeug vorgesehen ist. Der Öffnungsbefehl wird dabei wenigstens teilweise durch die Sensoren ausgelöst, wobei diese als kapazitiv wirkende Sensoren ausgebildet sind und Mittel aufweisen, deren kapazitive Kopplung zur Umgebung der Mittel geändert wird, um den Öffnungsbefehl teilweise auszulösen. Der Öffnungsbefehl wird verfahrensgemäß auch vollständig ausgelöst, die teilweise Auslösung des Öffnungsbefehls berücksichtig dabei lediglich eine zusätzliche Abfrage des Zugangsberechtigungsmittels.

Das Verfahren weist ferner den Vorteil auf, dass erst die kapazitive Kopplung des ersten Mittels des ersten Sensors und erst nachfolgend die kapazitive Kopplung des zweiten Mittels des zweiten Sensors geändert wird. Die Erzeugung der Änderung der kapazitiven Kopplung der Mittel der Sensoren wird durch eine Person erzeugt, wobei die Änderung der kapazitiven Kopplung des ersten Mittels des ersten Sensors durch eine sich dem Kraftfahrzeug annähernde Person und die Änderung der kapazitiven Kopplung des zweiten Mittels des zweiten Sensors durch die Bewegung eines Fußes und/oder eines Beines der Person erzeugt wird. Detektiert beispielsweise der zweite Sensor mit einem vertikal ausgerichteten Wirkbereich einen Gegenstand oder eine Person, beispielsweise wenn das Kraftfahrzeug auf einer Hebebühne steht, so wird der Öffnungsbefehl nicht ausgelöst, da die zuvor notwendige Detektion durch den ersten Sensor mit dem horizontalen Wirkbereich ausgeblieben ist. Dadurch wird vermieden, dass eine Öffnung der Klappe des Kraftfahrzeuges erfolgt, wenn lediglich ein Tier, ein Gegenstand wie ein Ball oder dergleichen unter dem Kraftfahrzeug herläuft oder bewegt wird. Damit wird die Sicherheit zur richtigen Erkennung des Öffnungswunsches der Person sichergestellt, wobei erst nachfolgend die Abfrage des Zugangsberechtigungsmittels erfolgt, so dass die Berechtigung der Person zur Öffnung der Klappe ebenfalls sichergestellt wird. Die Sensierung der Person durch die Sensoren kann sowohl bei geöffnetem Kraftfahrzeug als auch bei verriegeltem Kraftfahrzeug erfolgen.

Jedoch dann, wenn beispielsweise der Rückwärtsgang des Kraftfahrzeuges eingelegt ist, kann die erfindungsgemäße kapazitive Sensorik verfahrensgemäß ein Parkabstandskontrollsystem unterstützen.

Eine Kombination sowohl der elektronischen Parkhilfe als auch der Detektion des Öffnungswunsches kann insofern ermöglicht werden, als dass ein Gegenstand oder eine Person rückseitig am Kraftfahrzeug stehend im Kraftfahrzeug signalisiert wird, beispielsweise durch einen Warnton, und gleichzeitig bei stehendem Fahrzeug mit einer Fußbewegung durch Aktivierung des zweiten, vertikal wirkenden Sensors eine Öffnung der Klappe erfolgen kann. Folglich ist im Rahmen der vorliegenden Erfindung auch eine Doppelbelegung der Funktion der Sensoren möglich.

Weitere, die Erfindung verbessernde Maßnahmen werden nachstehend gemeinsam mit der Beschreibung eines bevorzugten Ausführungsbeispiels der Erfindung anhand von zwei Figuren näher dargestellt. Es zeigt:
- Fig. 1: eine schematische Ansicht eines Ausführungsbeispieles der vorliegenden Erfindung mit einem Kraftfahrzeug sowie einer Einrichtung zum selbsttätigen Öffnen wenigstens einer Klappe des Kraftfahrzeuges und
- Fig. 2: eine detaillierte Ansicht der Anordnung des ersten Sensors sowie des zweiten Sensors im Bereich des Kofferraumdeckels des Kraftfahrzeuges.

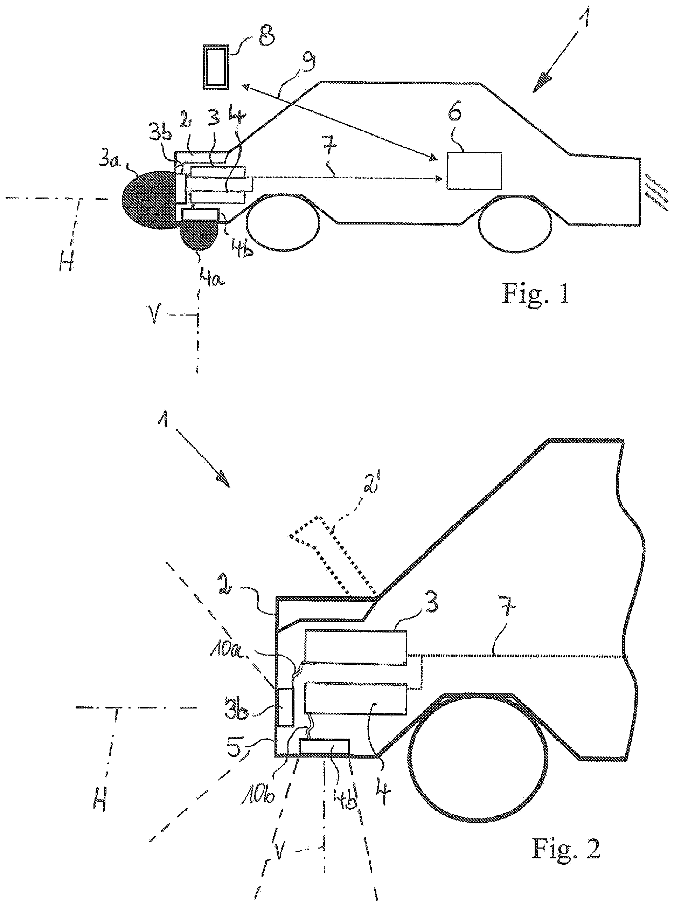

Figur 1 zeigt eine schematische Ansicht eines Ausführungsbeispieles der vorliegenden Erfindung. Hierin ist ein Kraftfahrzeug 1 schematisch dargestellt, das eine Klappe 2 besitzt, die als Kofferraumdeckel ausgeführt ist. Im Bereich des Stoßfängers des Kraftfahrzeuges 1 ist beispielhaft nur ein erster Sensor 3 mit einem ersten, horizontalen Wirkbereich 3a dargestellt, wobei der horizontale Wirkbereich hinter dem Fahrzeug in Richtung einer Horizontalen H ausgebildet ist. Ferner ist in den Stoßfänger beispielhaft nur ein zweiter Sensor 4 mit einem zweiten Wirkbereich 4a eingebracht, der sich in Richtung zur Vertikalen V der Unterseite des Kraftfahrzeuges hin erstreckt. Die Sensoren 3 und 4 sind jeweils aufgeteilt dargestellt, die den Steuerungs- bzw. Mikrocontrollerteil bilden, mit einer ersten Sensorelektrode 3b des ersten Sensors 3 und einer zweiten Sensorelektrode 4b des zweiten Sensors 4. Die Sensoren 3 und 4 können an beliebiger Stelle im Kraftfahrzeug 1, jedoch bevorzugt im Bereich der Sensorelektroden 3b und 4b angeordnet werden. Jedoch ist die erste Sensorelektrode 3b im Bereich der Außenhaut des Kraftfahrzeuges 1 angebracht, die vorliegend als Stoßfänger ausgeführt ist. Ferner ist die zweite Sensorelektrode 4b unterseitig am Stoßfänger angeordnet, um den vertikal nach unten gerichteten Bereich des Kraftfahrzeuges 1 zwischen dem Fahrzeugaufbau und der Fahrbahnoberfläche abzudecken.

Die Sensoren 3 und 4 sind über eine Verbindungsleitung 7 mit einem Steuergerät 6 verbunden. Die Klappe 2 besitzt zum Verschluss im Kraftfahrzeug 1 einen Verriegelungsmechanismus, der elektrisch ansteuerbar ist, so dass das Steuergerät 6 bei Empfang positiver Sensorsignale über die Verbindungsleitung 7 die elektronische Verriegelung des Kofferraumdeckels 2 des Kraftfahrzeuges 1 öffnen kann. Bevor jedoch die Öffnung des Kofferraumdeckels 2 durch das Steuergerät 6 erfolgt, wird zur weiteren Funktionsabsicherung eine Datenabfrage an ein Zugangsberechtigungsmittel 8 vorgenommen, das beispielsweise eine Person bei sich trägt.

Die Datenabfrage zwischen dem Steuergerät 6 und dem Zugangsberechtigungsmittel 8 erfolgt über eine drahtlose Verbindung 9, die beispielsweise eine Funkverbindung darstellen kann und nur in einem begrenzten Wirkungskreis möglich ist. Das Zugangsberechtigungsmittel 8 kann als ID-Geber des Besitzers des Fahrzeugs ausgebildet sein, so dass eine Aktivierung der Entriegelung des Kofferraumdeckels 2 im Kraftfahrzeug 1 nur dann zur Öffnung des Kofferraumdeckels 2 führt, wenn eine Authentifizierung einer Person durch das Zugangsberechtigungsmittel 8 erfolgt ist.

Figur 2 zeigt eine vergrößerte Ansicht des Heckbereiches des Kraftfahrzeuges 1, in dem die Sensoren 3 und 4 mit den zugeordneten Sensorelektroden 3b und 4b angeordnet sind. Ferner ist die Verbindungsleitung 7 gezeigt, die in Richtung des nicht weiter gezeigten Steuergerätes verläuft, um den teilweisen Öffnungsbefehl durch die Sensoren 3 und 4 zu übertragen. Die Klappe 2 des Kraftfahrzeuges 1 ist als Kofferraumdeckel 2 ausgeführt, und ist sowohl in einer geschlossenen Position gezeigt, wobei auch eine geöffnete Position durch einen gestrichelten Bereich 2' gezeigt ist. Die Verbindung zwischen den Sensoren 3 und 4 zu den Sensorelektroden 3b und 4b wird durch eine Leitungsverbindung 10a und 10b ermöglicht, wobei die Sensoren 3 und 4 mit den jeweiligen Sensorelektroden 3b und 4b auch einteilig in einem Gehäuse oder zusammenhängend ausgeführt sein können.

Die erste Sensorelektrode 3b ist rückwärtig am Stoßfänger 5 des Kraftfahrzeuges 1 angebracht und besitzt einen ersten, horizontalen Wirkbereich, der durch gestrichelte Linien angedeutet ist. Der Wirkbereich der zweiten Sensorelektrode 4b erstreckt sich in Richtung zur Vertikalen V und überschneidet sich nicht mit dem ersten Wirkbereich der ersten Sensorelektrode 3b. Jedoch ist auch ein fließender Übergang der jeweiligen Wirkbereiche möglich, wobei jedoch vermieden werden muss, dass die Person, die lediglich hinter das Kraftfahrzeug 1 tritt, durch seine Füße nicht durch den zweiten Sensor 4 detektiert wird, in dem der zweite Sensor 4 über die zweite Sensorelektrode 4b ausgelöst wird. Folglich sollte der zweite Wirkbereich derart unterhalb des Fahrzeuges gelegt sein, dass erst bei einer aktiven Fußbewegung eine Auslösung des zweiten Sensors 4 erfolgt.

Die Erfindung beschränkt sich in ihrer Ausführung nicht auf das vorstehend angegeben bevorzugte Ausführungsbeispiel. Vielmehr ist eine Anzahl von Varianten denkbar, welche von der dargestellten Lösung auch bei grundsätzlich anders gearteten Ausführungen Gebrauch macht.

### Bezugszeichenliste

- 1: Kraftfahrzeug
- 2: Klappe
- 2': Klappe geöffnet
- 3: erster Sensor
- 3a: erster Wirkbereich
- 3b: erste Sensorelektrode
- 4: zweiter Sensor
- 4a: zweiter Wirkbereich
- 4b: zweite Sensorelektrode
- 5: Stoßfänger
- 6: Steuergerät
- 7: Verbindungsleitung
- 8: Zugangsberechtigungsmittel
- 9: drahtlosen Verbindung
- 10a: Leitungsverbindung
- 10b: Leitungsverbindung
- H: Horizontale
- V: Vertikale

## Patentansprüche

1. Kraftfahrzeug (1) mit wenigstens einer Klappe (2), die nach einem Öffnungsbefehl selbsttätig öffnet oder nach einem Schließbefehl selbstständig schließt, wobei wenigstens ein erster Sensor (3) mit einem ersten, horizontalen Wirkbereich (3a) und wenigstens ein zweiter Sensor (4) mit einem zweiten, vertikalen Wirkbereich (4a) am Kraftfahrzeug (1) vorgesehen ist, wobei der Öffnungsbefehl teilweise durch die Sensoren (3,4) auslösbar ist,
wobei ein Steuergerät (6) vorhanden ist, das mit den Sensoren (3, 4) über eine Verbindungsleitung (7) wirkverbunden ist, und wobei ein Zugangsberechtigungsmittel (8) in Form eines ID-Gebers oder einer Key-Less-Go Card vorhanden ist, das mit dem Steuergerät (6) mittels einer drahtlosen Verbindung (9) verbindbar ist,
**dadurch gekennzeichnet, dass** die Sensoren (3, 4) als kapazitiv wirkende Sensoren (3, 4) ausgebildet sind und Mittel aufweisen, mit denen eine Änderung einer kapazitiven Kopplung zwischen den Mitteln und einer Umgebung der Mittel sensierbar ist, und dass das Zugangsberechtigungsmittel (8) Steuergerät (6) erst nach der Sensierung der Person durch den ersten Sensor (3) und den zweiten Sensor (4) abfragbar ist, ob der Öffnungsbefehl zur selbsttätigen Öffnung der Klappe (2) ausgelöst werden darf, wobei die Sensoren (3,4) unabhängig vom Parkabstandskontrollsystem wirken.

2. Kraftfahrzeug (1) nach Anspruch 1, **dadurch gekennzeichnet, dass** die Mittel des ersten Sensors (3) eine erste Sensorelektrode (3b) und die Mittel des zweiten Sensors (4) eine zweite Sensorelektrode (4b) aufweisen.

3. Kraftfahrzeug (1) nach Anspruch 2, **dadurch gekennzeichnet, dass** eine oder jede Sensorelektrode (3b, 4b) als flächenförmiges Element ausgebildet ist, wobei am Kraftfahrzeug (1) ein Stoßfänger (5) vorhanden ist, in oder an dem das oder jedes flächenförmige Element anordbar ist.

4. Kraftfahrzeug (1) nach Anspruch 1 bis 3, **dadurch gekennzeichnet, dass** die Einbauumgebung der Sensorelektroden (3b, 4b) eine Dielektrizitätskonstante aufweist, deren Änderung durch die Sensorelektroden (3b, 4b) detektierbar ist.

5. Kraftfahrzeug (1) nach Anspruch 2 bis 4, **dadurch gekennzeichnet, dass** die oder jede Sensorelektrode (3b, 4b) auf der Innenseite des Stoßfängers (5) aufgeklebt oder aufgeklipst ist.

6. Kraftfahrzeug (1) nach einem der vorgenannten Ansprüche, **dadurch gekennzeichnet, dass** die Klappe (2) als Kofferraumdeckel (2) des Kraftfahrzeuges (1) ausgebildet ist, wobei die Sensoren (3, 4) zur Detektion der Annäherung und/oder des Vorhandenseins einer Person und/oder eines Gegenstandes ausgeführt sind.

7. Kraftfahrzeug (1) nach einem der Ansprüche 2 bis 6, **dadurch gekennzeichnet, dass** eine oder jede Sensorelektrode (3b, 4b) im oder am Kofferraumdeckel (2), einem Flügelelement oder dergleichen angeordnet ist.

8. Kraftfahrzeug (1) nach einem der Ansprüche 3 bis 7, **dadurch gekennzeichnet, dass** eine oder jede Sensorelektrode (3b, 4b) als ein Draht oder eine Leiterfolie ausgeführt ist, der oder die über wenigstes einem Teil der Breite des Stoßfängers (5) des Kraftfahrzeugs (1) im oder am Stoßfänger (5) verlegt ist.

9. Kraftfahrzeug (1) nach einem der vorgenannten Ansprüche, **dadurch gekennzeichnet, dass** die erste Sensorelektrode (3b) im vertikal verlaufenden und zur Rückseite weisenden Bereich des Stoßfängers (5) und die zweite Sensorelektrode (3b) im wenigstens näherungsweise horizontal verlaufenden und zur Unterseite weisenden Bereich des Stoßfängers (5) angeordnet ist.

10. Verfahren zur Auslösung eines Öffnungsbefehls zum selbsttätigen Öffnen wenigstens einer an einem Kraftfahrzeug (1) vorhandenen Klappe (2), wobei ein erster Sensor (3) mit einem ersten, horizontalen Wirkbereich (3a) und wenigstens ein zweiter Sensor (4) mit einem zweiten, vertikalen Wirkbereich (4a) am Kraftfahrzeug (1) vorgesehen ist, wobei der Öffnungsbefehl teilweise durch die Sensoren (3, 4) auslösbar ist und wobei die Sensoren (3,4) als kapazitiv wirkende Sensoren (3,4) ausgebildet sind und Mittel aufweisen, deren kapazitive Kopplung zur Umgebung der Mittel geändert wird, um den Öffnungsbefehl teilweise auszulösen, wobei ein Zugangsberechtigungsmittel (8) vorhanden ist und erst nach der Sensierung der Person durch den ersten Sensor (3) und den zweiten Sensor (4) eine Abfrage des Zugangsberechtigungsmittels (8) vorgenommen wird, um den Öffnungsbefehl zum selbsttätigen Öffnen der Klappe (2) auszulösen, wobei die Sensoren (3,4) unabhängig vom Parkabstandskontrollsystem wirken.

11. Verfahren nach Anspruch 10, **dadurch gekennzeichnet, dass** erst die kapazitive Kopplung des ersten Mittels des ersten Sensors (3) und nachfolgend die kapazitive Kopplung des zweiten Mittels des zweiten Sensors (4) geändert wird.

12. Verfahren nach Anspruch 10 oder 11, **dadurch gekennzeichnet, dass** die Erzeugung der Änderung der kapazitiven Kopplung der Mittel der Sensoren (3, 4) durch eine Person erzeugt wird, wobei die Änderung der kapazitiven Kopplung des ersten Mittels des ersten Sensors (3) durch eine sich dem Kraftfahrzeug (1) annähernde Person und die Änderung der kapazitiven Kopplung des zweiten Mittels des zweiten Sensors (3) durch die Bewegung eines Fußes und/oder Beines der Person erzeugt wird.

## Claims

1. Vehicle (1) with at least one lid (2) that opens automatically following an opening command or closes automatically following a closing command, where at least one first sensor (3) is provided with a first, horizontal operating area (3a) and at least one second sensor (4) is provided with a second, vertical operating area (4a) on the vehicle (1), where the opening command can be partially triggered by the sensors (3, 4), where a control device (6) is available and has an operative connection to the sensors (3, 4) via a connection cable (7) and where an access authorization instrument (an ID encoder or keyless go card) is available that can be connected to the control device (6) using a wireless connection (9), **wherein** the sensors (3, 4) are designed as capacitive sensors (3, 4) and feature instruments that can be used to detect a capacitive coupling change between the instruments and their environment, and wherein only after the first person is detected by the first sensor (3) and the second sensor (4) can the query be sent to the access authorization instrument (8) to determine whether the opening command for automatic lid (2) opening is permitted to be triggered, where the sensors (3, 4) operate independently of the parking distance monitoring system.

2. Vehicle (1) in accordance with claim 1, **wherein** the instrument for the first sensor (3) features a first sensor bar (3b) and the instrument for the second sensor (4) features a second sensor bar (4b).

3. Vehicle (1) in accordance with claim 2, **wherein** one or both sensor bars (3b, 4b) are designed as a sheet-like element, where a bumper (5) in or on which one or each sheet-like element can be positioned is attached to the vehicle (1).

4. Vehicle (1) in accordance with claims 1 through 3, **wherein** the installation area for the sensor bars (3b, 4b) features a dielectric constant, where a change in this value can be detected by the sensor bars (3b, 4b).

5. Vehicle (1) in accordance with claims 2 through 4, **wherein** one or each sensor bar (3b, 4b) is glued or clipped onto the inside of the bumper (5).

6. Vehicle (1) in accordance with the aforementioned claims, **wherein** the lid (2) is designed as the trunk lid (2) of the vehicle (1), where the sensors (3,4) are designed to detect the approaching movement or presence of a person and/or an object.

7. Vehicle (1) in accordance with one of the claims 2 through 6, **wherein** one or each sensor bar (3b, 4b) is positioned in or on the trunk lid (2), a fender element or similar part.

8. Vehicle (1) in accordance with one of the claims 3 through 7, **wherein** one or each sensor bar (3b, 4b) is designed as a wire or conductor foil that is routed across at least part of the width of the bumper (5) of the vehicle (1), either in or on the bumper (5).

9. Vehicle (1) in accordance with one of the aforementioned claims, **wherein** the first sensor bar (3b) is vertically positioned with the area of the bumper (5) facing towards the rear and the second sensor bar (4b) is at least in an approximate horizontal position with the area of the bumper (5) facing the underside of the vehicle.

10. Procedure for triggering an opening command for automatic opening of at least one lid (2) attached to a vehicle (1), where a first sensor (3) provided with a first, horizontal operating area (3a) and at least one second sensor (4) provided with a second, vertical operating area (4a) are attached to the vehicle (1), where the opening command can be partially triggered by the sensors (3, 4) and where the sensors are designed as capacitive sensors (3, 4) and feature instruments whose capacitive coupling to their environment is changed to partially trigger the opening command, where an access authorization instrument (8) is available and after a person is detected by the first sensor (3), this access authorization instrument (8) is prompted to trigger the opening command for automatic opening of the lid (2), where the sensors (3, 4) operate independently of the parking distance monitoring system.

11. Procedure in accordance with claim 10, **wherein** the capacitive coupling for the first instrument of the first sensor (3) and then the capacitive coupling for the second instrument for the second sensor (4) are changed.

12. Procedure in accordance with claim 10 or 11, **wherein** a person causes a capacitive coupling change to the instruments of the sensors (3, 4), where the capacitive coupling change to the first instrument of the first sensor (3) is caused by a person approaching the vehicle (1) and the capacitive coupling change to the second instrument of the second sensor (3) is caused by a person's foot or leg movement.

## Revendications

1. - Véhicule automobile (1) avec au moins un volet (2) qui s'ouvre automatiquement après une commande d'ouverture ou qui se ferme automatiquement après une commande de fermeture, étant prévu au moins un premier capteur (3) avec une première zone efficace horizontale (3a) et au moins un deuxième capteur (4) avec une deuxième zone efficace verticale (4a) sur le véhicule automobile (1), la commande d'ouverture pouvant être déclenchée partiellement par les capteurs (3, 4), une unité de contrôle (6) étant présente qui se trouve en liaison active avec les capteurs (3, 4) au moyen d'une ligne de connexion (7) et un moyen de droit d'accès (8) étant présent sous forme d'un transmetteur d'identification (ID) ou d'une carte d'autorisation de démarrage sans clé (Keyless Go Card) qui peut être lié(e) à l'unité de contrôle (6) au moyen d'une liaison sans fil (9),
**caractérisé en ce que**
les capteurs (3, 4) sont réalisés en tant que capteurs (3, 4) agissants de manière capacitive et présentent des moyens avec lesquels une modification d'un couplage capacitif entre les moyens et un environnement des moyens est détectable et que le moyen de droit d'accès (8) ne peut être interrogé par l'unité de contrôle (6) qu'après la détection de la personne par le premier capteur (3) et le deuxième capteur (4) si la commande d'ouverture pour ouvrir automatiquement le volet (2) peut être déclenché, les capteurs (3, 4) agissant indépendamment du système de contrôle de la distance de stationnement.

2. - Véhicule automobile (1) selon la revendication 1,
**caractérisé en ce que** les moyens du premier capteur (3) présentent une première électrode de capteur (3b) et les moyens du deuxième capteur (4) présentent une deuxième électrode de capteur (4b).

3. - Véhicule automobile (1) selon la revendication 2,
**caractérisé en ce qu**'une ou chaque électrode de capteur (3b, 4b) est réalisée en tant qu'élément à surface plane, un pare-chocs (5) étant présent sur le véhicule automobile (1) dans ou sur lequel l'élément ou chaque élément à surface plane peut être disposé.

4. - Véhicule automobile (1) selon les revendications 1 à 3,
**caractérisé en ce que** l'environnement de montage des électrodes de capteur (3b, 4b) présente une constante diélectrique dont la modification peut être détectée par les électrodes de capteur (3b, 4b).

5. - Véhicule automobile (1) selon les revendications 2 à 4,
**caractérisé en ce que** l'électrode ou chaque électrode de capteur (3b, 4b) est collée ou clipsée sur le côté intérieur du pare-chocs (5).

6. - Véhicule automobile (1) selon l'une des revendications précédentes, **caractérisé en ce que** le volet (2) est réalisé en tant que couvercle de coffre (2) du véhicule automobile (1), les capteurs (3, 4) étant réalisés pour détecter l'approche et/ou la présence d'une personne et/ou d'un objet.

7. - Véhicule automobile (1) selon l'une des revendications 2 à 6,
**caractérisé en ce qu**'une ou chaque électrode de capteur (3b, 4b) est disposée dans ou sur le couvercle de coffre (2), un élément de profil d'aile ou d'autres choses semblables.

8. - Véhicule automobile (1) selon l'une des revendications 3 à 7,
**caractérisé en ce qu**'une ou chaque électrode de capteur (3b, 4b) est réalisée en tant que fil ou feuille conductrice qui est posé(e) sur au moins une partie de la largeur du pare-chocs (5) du véhicule automobile (1) dans ou sur le pare-chocs (5).

9. - Véhicule automobile (1) selon l'une des revendications précédentes, **caractérisé en ce que** la première électrode de capteur (3b) est disposée dans la zone verticale et orientée vers la face arrière du pare-chocs (5) et la deuxième électrode de capteur (3b) est disposée dans la zone au moins approximativement horizontale et orientée vers la partie inférieure du pare-chocs (5).

10. - Procédé pour déclencher une commande d'ouverture pour ouvrir automatiquement d'au moins un volet (2) présent sur un véhicule automobile (1), un premier capteur (3) étant prévu avec une première zone efficace horizontale (3a) et au moins un deuxième capteur (4) avec une deuxième zone efficace verticale (4a) au véhicule automobile (1), la commande d'ouverture pouvant être déclenchée partiellement par les capteurs (3, 4) et les capteurs (3, 4) étant réalisés en tant que capteurs (3, 4) agissants de manière capacitive et présentant des moyens dont le couplage capacitif par rapport à l'environnement des moyens sera modifié pour déclencher partiellement la commande d'ouverture, un moyen de droit d'accès (8) étant présent et une interrogation du moyen de droit d'accès (8) ne sera effectuée qu'après la détection de la personne par le premier capteur (3) et le deuxième capteur (4), pour déclencher la commande d'ouverture pour ouvrir automatiquement le volet (2), les capteurs (3, 4) agissant indépendamment du système de contrôle de la distance de stationnement.

11. - Procédé selon la revendication 10,
**caractérisé en ce que** d'abord le couplage capacitif du premier moyen du premier capteur (3) et puis le couplage capacitif du deuxième moyen du deuxième capteur (4) sera modifié.

12. - Procédé selon la revendication 10 ou 11,
**caractérisé en ce que** la génération de la modification du couplage capacitif des moyens des capteurs (3, 4) sera générée par une personne, la modification du couplage capacitif du premier moyen du premier capteur (3) étant générée par une personne qui s'approche du véhicule automobile (1) et la modification du couplage capacitif du deuxième moyen du deuxième capteur (3) étant générée par le mouvement d'un pied et/ou d'une jambe de la personne.
